# EUROPEAN PATENT SPECIFICATION

(11) **EP 4 503 347 B1**
(45) Date of publication and mention of the grant of the patent: **04.11.2026**
(21) Application number: 23845908.5
(22) Date of filing: 30.03.2023
(51) Int. Cl.: B62J 45/00, H05K 5/00, H05K 5/06, B60R 16/02, H01R 13/52, H05K 3/34

(54) **CONNECTOR UNIT AND VEHICLE-MOUNTED CONNECTOR DEVICE**
VERBINDEREINHEIT UND FAHRZEUGMONTIERTE VERBINDERVORRICHTUNG
UNITÉ DE CONNECTEUR ET DISPOSITIF DE CONNECTEUR MONTÉ SUR VÉHICULE

(30) Priority: 27.07.2022 JP 2022119466
(43) Date of publication of application: 05.02.2025
(73) Proprietor: Japan Aviation Electronics Industry, Limited, Tokyo 150-0043 (JP)
(72) Inventor: NAKAMURA, Kazunobu, Tokyo 150-0043 (JP); LI, Teng, Tokyo 150-0043 (JP); IWAO, Naoki, Tokyo 150-0043 (JP)
(74) Representative: MERH-IP Matias Erny Reichl Hoffmann Patentanwälte PartG mbB
(86) International application number: PCT/JP2023/013055
(87) International publication number: WO 2024/024168

(56) References cited:
- WO-A1-2009/090998
- CN-A- 106 208 174
- CN-U- 211 167 211
- CN-U- 211 167 211
- IT-A1- TO20 121 043
- JP-A- 2000 023 332
- JP-A- 2013 016 288
- JP-A- 2013 016 288
- JP-A- 2020 077 557
- US-A1- 2020 403 353

## Description

### [TECHNICAL FIELD]

The present invention relates to a connector unit that can be used by being attached to another device of a vehicle or the like.

### [BACKGROUND ART]

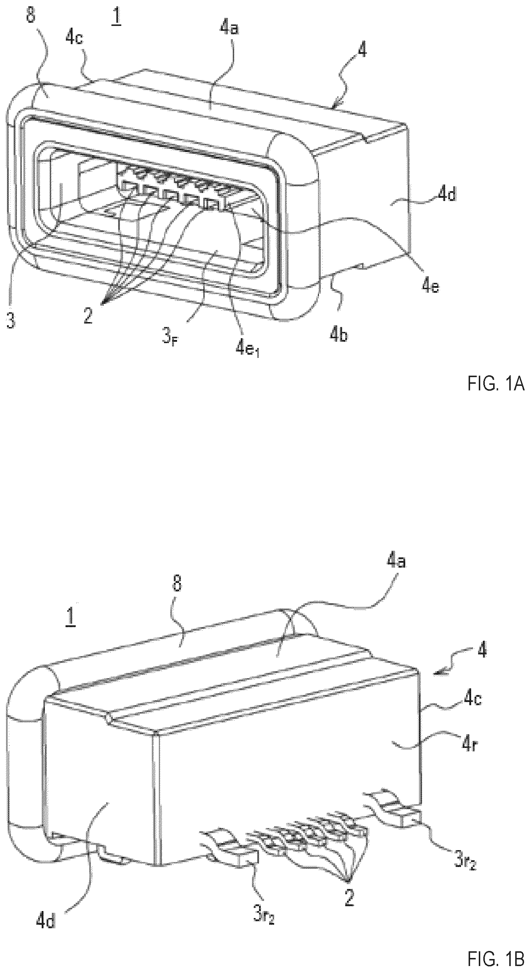

Some prior art waterproof connectors reliably prevent water or the like from seeping through a gap between components forming the connector due to capillary action (for example, see Patent literature 1). FIGS. 1A and 1B are diagrams for describing the waterproof connector of the prior art. As shown in FIGS. 1A and 1B, the waterproof connector includes highly conductive contacts 2, a metal shell 3 formed from a metal tube body inside which the contacts are disposed, an electrically insulating housing 4 where the contacts 2 are fixed, and an external waterproof sealing member 8 formed from annular sealing packing having an opening that is large enough to be attached to an outer periphery of the housing 4, where the housing 4 allows the contacts 2 to be disposed inside the metal shell 3 while being separated from an inner wall to be in an electrically insulated state, the housing 4 being formed from resin molded articles 4a to 4e and 4e₁ that are integrally molded by injection of electrically insulating synthetic resin. Patent literature 2 generally relates to fuel gas consumption measuring devices, in particular natural gas, and more specifically to an electrical connector for a fuel gas consumption measuring device. Patent literature 3 generally discloses an AC adapter having a USB terminal as an output terminal, the housing constituting the AC adapter consists of an upper case and a lower case. A waterproof rib is disposed, respectively, in the upper and lower cases so as to surround the USB terminal, and a waterproof wall structure surrounding the periphery of the USB terminal is provided by joining the waterproof ribs of the upper and lower cases by means of ultrasonic welding. Patent literature 4 generally discloses an electrical junction box that consists of a housing block 1, consisting of a block main part 10, which has connection terminals 13 inserted into a corresponding auxiliary machine 40 and a hood 11, which is made to protrude from the outer surface of the block main part and a junction box main part 2 to which the housing block 1 is attached. An inclined drain path 12 is formed in the bottom wall surface 14 of the block main part, which faces the opening 11a of the hood and, furthermore, the drain outlet 12a of the drain path 12 is formed in one sidewall of the block main part. A drain hole 22 linked with the drain outlet 12a is formed in a circumferential wall 21 of the junction box main part. The drain outlet is connected to an entrance 22a of the drain hole smoothly. Water penetrating through a gap between the outer surface 40a of the auxiliary machine is drained out of the junction box main part. Patent literature 5 generally relates to the technical field of waterproof protective sleeves, and more particularly, relates to a riding vehicle-mounted quick charging and waterproof structure.

### [PRIOR ART LITERATURE]

### [PATENT LITERATURE]

Patent literature 1: JP 2012-059540 A
Patent literature 2: IT TO20 121 043 A1
Patent literature 3: JP 2013 016288 A
Patent literature 4: JP 2000 023332 A
Patent literature 5: CN 211 167 211 U

### [SUMMARY OF THE INVENTION]

### [PROBLEMS TO BE SOLVED BY THE INVENTION]

However, when a waterproof connector 1 of Patent literature 1 is mounted on a device with a front opening 3_{F} facing upward, a connector removal side of the waterproof connector 1 is kept facing upward while being used. The waterproof connector 1 does not include a water discharge structure, and when water enters the housing 4 for some reasons, the water is retained inside the housing 4. Even a small amount of water, if retained for an extended time, may rust front end parts of a plurality of contacts 2 of the waterproof connector 1 that are exposed inside the housing 4. The problem with the waterproof connector 1 of Patent literature 1 has been that there is a constraint on attitude at the time of mounting on a device because it has to be mounted on a device with the front opening 3_{F} facing downward, for example, so that the waterproof connector 1 is not used with the connector removal side facing upward.

In view of the problem described above, an object of the present invention is to provide a connector unit with which a constraint on an attitude at the time of use can be relaxed.

### [MEANS TO SOLVE THE PROBLEMS]

To solve the problem described above, the present disclosure provides a connector unit and a vehicle-mounted connector device, having the features of respective independent claims. The dependent claims relate to embodiments thereof.

According to an example not encompassed by the claims but useful for understanding the present disclosure, a connector unit according to a present example comprises a printed wiring board, an interface connector, a waterproof sealing member, and a case. The printed wiring board having a flat plate shape includes a first region and a second region that is adjacent to the first region. The interface connector is mounted on the first region of the printed wiring board, and includes a shell having a non-watertight structure. The waterproof sealing member covers a boundary between the first region and the second region of the printed wiring board. The case includes an opening portion for allowing insertion/removal of a mating connector of the interface connector, and houses the printed wiring board, the interface connector, and the waterproof sealing member. The waterproof sealing member is formed so as to cover an outer periphery of the boundary of the printed wiring board and an inner periphery of the case facing toward the outer periphery of the boundary in a close contact manner, and separate inside of the case into the first region side and the second region side across the waterproof sealing member. The second region side inside the case is a waterproof region.

### [EFFECTS OF THE INVENTION]

According to the present embodiment, the interface connector having a non-watertight structure is mounted on the first region side inside the case. Accordingly, even when the opening portion faces upward in an attached state and water is retained in the first region, the water is not kept retained inside the interface connector as long as the water is in small quantity, and the water is discharged outside the interface connector. The second region side inside the case is a waterproof region, and a waterproof function is achieved. Accordingly, the connector unit of the present embodiment can relax a constraint on an attitude at the time of use. More particularly, in the case where the connector unit of the present embodiment is used as a vehicle-mounted connector device including a holding tool to be attached to a handlebar of a motorcycle, a degree of freedom can be ensured with respect to an angle of attachment to the handlebar, and attachment at an attitude where the opening portion faces upward is enabled.

### [BRIEF DESCRIPTION OF THE DRAWINGS]

[FIG. 1A] FIG. 1A is a diagram for describing a waterproof connector of a prior art;
[FIG. 1B] FIG. 1B is a diagram for describing the waterproof connector of the prior art;
[FIG. 2A] FIG. 2A is a perspective view showing an example of a connector unit according to a present embodiment;
[FIG. 2B] FIG. 2B is a side view of the connector unit shown in FIG. 2A;
[FIG. 3A] FIG. 3A is a rear view of the connector unit shown in FIG. 2A;
[FIG. 3B] FIG. 3B is a cross-sectional view taken along a line C-C in FIG. 3A;
[FIG. 4] FIG. 4 is an exploded perspective view of the connector unit shown in FIG. 2A;
[FIG. 5A] FIG. 5A is a perspective view showing a printed circuit board 35 of the connector unit shown in FIG. 2A;
[FIG. 5B] FIG. 5B is a side view of a printed wiring board 30 shown in FIG. 5A;
[FIG. 6A] FIG. 6A is a perspective view of the printed circuit board 35 where a waterproof sealing member 60 is integrally formed;
[FIG. 6B] FIG. 6B is a cross-sectional view seen from an interface connector 40 side, where a connector unit 100 is cut along a surface including a boundary 30c;
[FIG. 7A] FIG. 7A is an exploded perspective view of a waterproof sealing member 61, where the waterproof sealing member 61 is to be mounted on the printed circuit board 35;
[FIG. 7B] FIG. 7B is a cross-sectional view seen from the interface connector 40 side, where the connector unit 100 where the waterproof sealing member 61 is mounted is cut along the surface including the boundary 30c;
[FIG. 8A] FIG. 8A is a rear view showing an example of the connector unit, where a rear surface cover 80 is included;
[FIG. 8B] FIG. 8B is a cross-sectional view taken along a line C-C in FIG. 8A;
[FIG. 9A] FIG. 9A is a diagram showing an example of attachment of the connector unit 100 to another device of a vehicle or the like, FIG. 9A showing a state where the connector unit 100 is attached to a handlebar of a motorcycle using a holding tool;
[FIG. 9B] FIG. 9B is a side view of FIG. 9A; and
[FIG. 9C] FIG. 9C is a rear view of FIG. 9A, FIG. 9C showing a part of a case holding part 210 and a harness connector 400.

### [DETAILED DESCRIPTION OF THE EMBODIMENTS]

Hereinafter, an embodiment of the present invention will be described with reference to the drawings. Additionally, in the following description, structural parts having a same function are denoted by a same number, and a redundant description will be omitted.

### <Connector Unit>

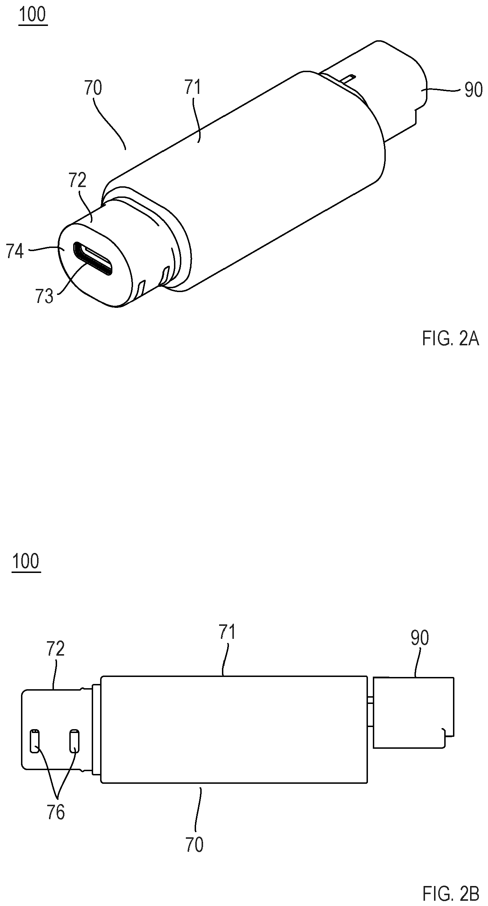

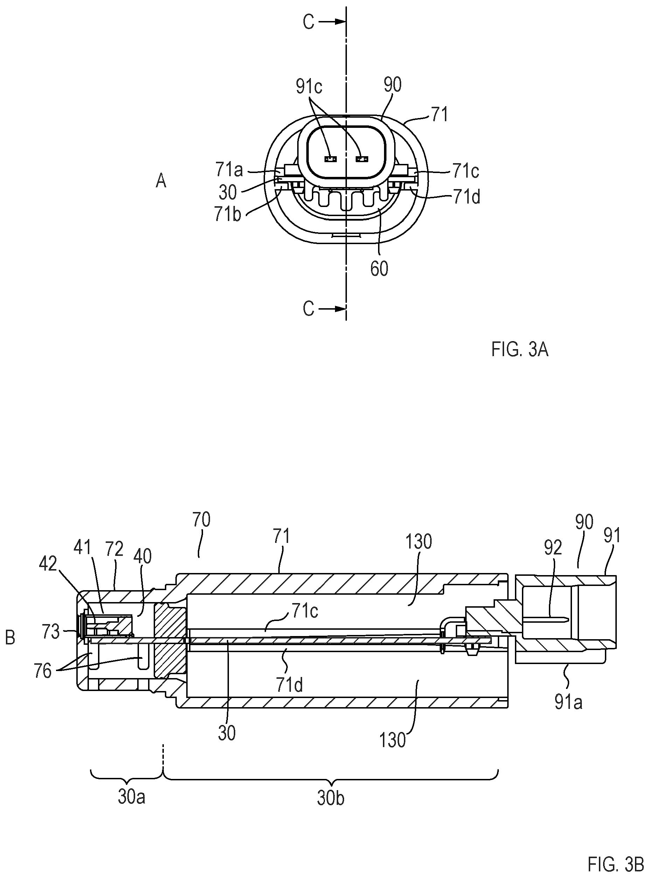

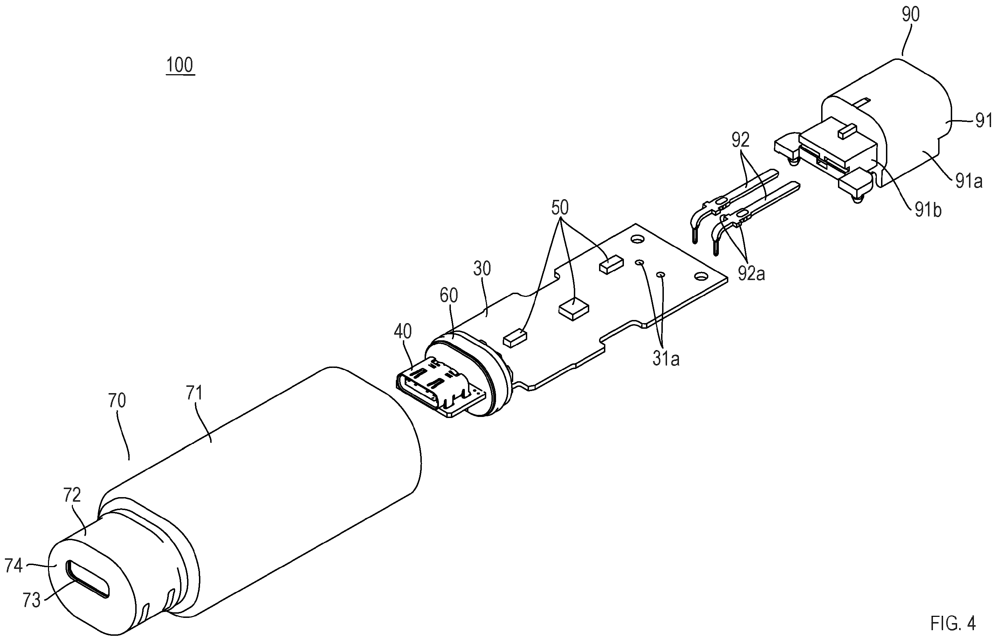

FIG. 2A is a perspective view showing an example of a connector unit according to a present embodiment, and FIG. 2B is a side view thereof. FIG. 3A is a rear view of the connector unit shown in FIG. 2A, and FIG. 3B is a cross-sectional view taken along a line C-C in FIG. 3A. FIG. 4 is an exploded perspective view of the connector unit shown in FIG. 2A. In FIG. 3A, potting resin 130 described later is not shown, and in FIG. 3B, electronic components 50 are not shown.

As shown in FIG. 4, a connector unit 100 according to the present embodiment is mainly formed from a printed wiring board 30, an interface connector 40, electronic components 50, a waterproof sealing member 60, a case 70, and a rear surface connector 90.

### (Printed Wiring Board 30)

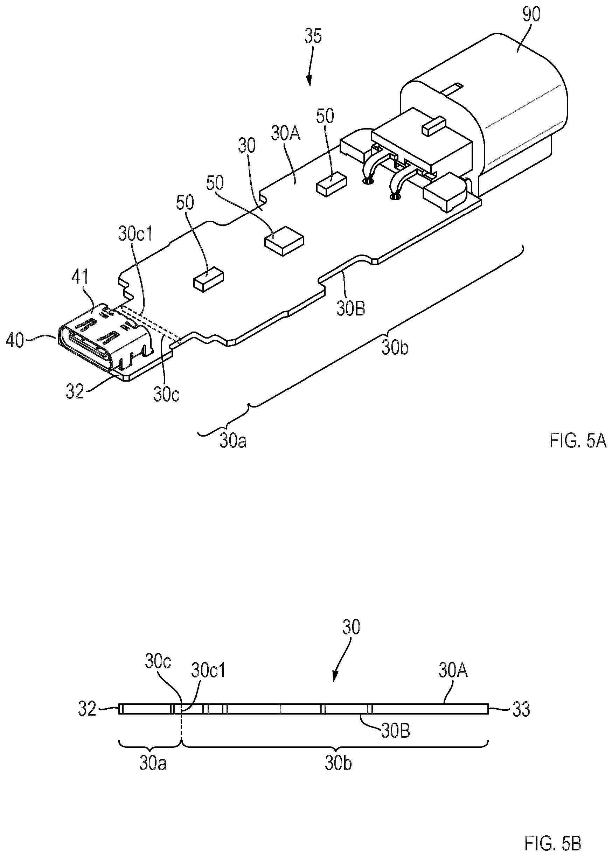

The printed wiring board 30 is a single or multi-layer wiring board that is mainly composed of glass epoxy resin, for example. FIG. 5A is a perspective view showing a printed circuit board 35 of the connector unit shown in FIG. 2A, and FIG. 5B is a side view of the printed wiring board 30 shown in FIG. 5A.

As shown in FIGS. 5A and 5B, the printed wiring board 30 according to the present embodiment has a flat plate shape including an upper surface 30A and a lower surface 30B having a substantially rectangular shape, and includes an end part 32 including an end surface corresponding to one end in a lengthwise direction, and an end part 33 including an end surface on an opposite side from the end part 32. The printed wiring board 30 includes a first region 30a that extends from the end part 32 in a direction of the end part 33, and a second region 30b that is adjacent to the first region 30a and that extends to the end part 33. When a surface at a boundary between the first region 30a and the second region 30b is defined as a boundary 30c, the first region 30a is a region of the printed wiring board 30 from the end part 32 to the boundary 30c, and the second region 30b is a region of the printed wiring board 30 from the boundary 30c to the end part 33.

The interface connector 40, the electronic components 50, and the rear surface connector 90 are mounted on the upper surface 30A of the printed wiring board 30. In the present embodiment, the printed wiring board 30 where the interface connector 40, the electronic components 50, and the rear surface connector 90 are mounted will be referred to as "printed circuit board 35". As shown in FIGS. 3A and 3B, the printed circuit board 35 is housed in the case 70.

### (Interface Connector 40)

The interface connector 40 to be connected to a connector of a smartphone or the like is mounted on the upper surface 30A of the printed wiring board 30, on the end part 32 side of the first region 30a. As shown in FIGS. 3B to 5A, a terminal 42 of the interface connector 40 is covered by a metal shell 41 have a non-watertight structure, and is positioned facing outside of the case 70 through an opening portion 73 provided in a front plate part 74 of the case 70. The interface connector 40 according to the present embodiment is a USB Type-C connector. However, the type of the interface connector 40 is not particularly limited as long as the interface connector is an interface connector having a non-watertight structure. For example, other interface connectors such as a USB Type-A connector or an HDMI (registered trademark) connector may be used. Because the interface connector 40 has a non-watertight structure, even when the interface connector 40 receives water through the opening portion 73, the water is not retained inside the interface connector 40 as long as the water is in small quantity, and the water is discharged outside the interface connector.

### (Electronic Component 50)

The electronic components 50, which are surface mount components such as an IC chip and a capacitor, are mounted on the upper surface 30A of the printed wiring board 30, on the second region 30b side. With respect to the electronic components 50 according to the present embodiment, a plurality of electronic components 50 are mounted, as shown in FIG. 5A. However, the number of electronic components 50 on the printed wiring board 30 of the connector unit 100 according to the present embodiment is not limited to plural. Moreover, as described later, in the present embodiment, the first region 30a side inside the case 70 is a non-waterproof region, and the second region 30b side is a waterproof region. Accordingly, the electronic components 50 according to the present embodiment may include an electronic component that requires high waterproofness than the interface connector 40. Additionally, in the case where the connector unit 100 of the present embodiment can be implemented without the electronic components 50, the electronic components 50 do not necessarily have to be mounted.

### (Waterproof Sealing Member 60)

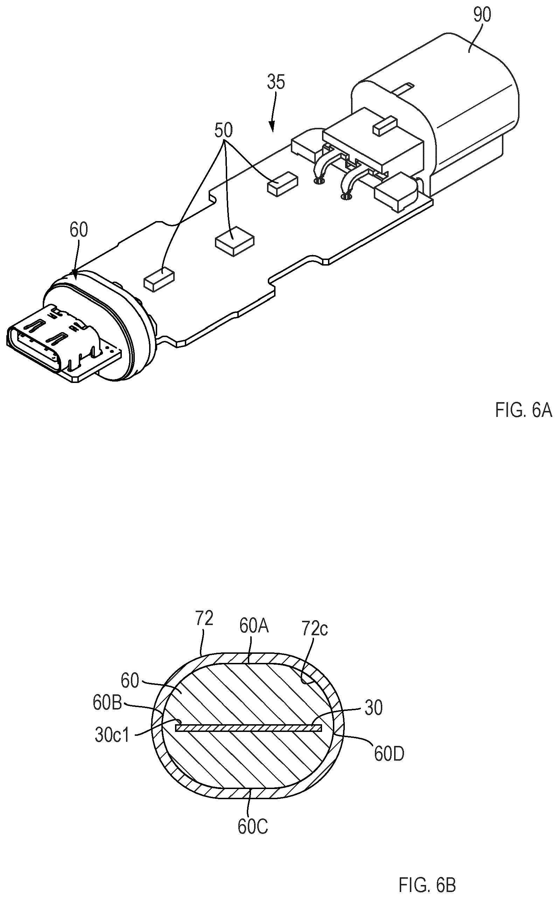

A waterproof sealing member 60 formed from a hot melt material is formed on an outer periphery 30c1 of the boundary 30c of the printed wiring board 30. FIG. 6A is a perspective view of the printed circuit board 35 where the waterproof sealing member 60 is integrally formed. FIG. 6B is a cross-sectional view seen from the interface connector 40 side, where the connector unit 100 is cut along a surface including the boundary 30c. In FIG. 6B, the printed wiring board 30 and the rear surface connector 90 on a backward side (a rear side) of the boundary 30c are not shown.

An external waterproof sealing member 8 as shown in FIGS. 1A and 1B that is formed from annular sealing packing cannot be mounted on the printed wiring board 30 having a flat plate shape, but as shown in FIGS. 6A and 6B, the waterproof sealing member 60 of the present embodiment is integrally formed with the printed wiring board 30 by tightly contacting the printed wiring board 30 while extending along and covering the outer periphery 30c1 of the boundary 30c of the printed wiring board 30. As shown in FIG. 6B, the waterproof sealing member 60 formed on the printed wiring board 30 includes pressing surfaces 60A, 60B, 60C, and 60D that press an inner surface of a tubular part 72 when inserted inside the case 70. The pressing surface 60A and the pressing surface 60B, the pressing surface 60B and the pressing surface 60C, the pressing surface 60C and the pressing surface 60D, and the pressing surface 60D and the pressing surface 60A are continuous to each other, and a surface that is continuous as a whole is formed. The pressing surfaces 60A, 60B, 60C, and 60D press an inner periphery 72c that is an inner periphery of the tubular part 72 of the case 70 and that faces toward the outer periphery 30c1, and are thus in close contact with the inner surface of the tubular part 72. When the waterproof sealing member 60 is formed in the above manner, the waterproof sealing member 60 separates inside of the case 70 into the first region 30a side and the second region 30b side.

Furthermore, the second region 30b side of the inside of the case 70 according to the present embodiment is a waterproof region. For example, to achieve the waterproof region, the potting resin 130 is injected or the rear surface connector 90 is provided, and details will be given later.

By providing the waterproof sealing member 60 and making the second region 30b side inside the case 70 a waterproof region, a waterproof function is achieved on the second region 30b side even when water enters from a rear end side of the case 70 (a side of the case 70 opposite from the front plate part 74), not to mention a case where water enters through the opening portion 73 of the case 70. Accordingly, the electronic components 50 and the printed wiring board 30 on the second region 30b side inside the case 70 are not affected by water regardless of which orientation the connector unit 100 is attached to another device of a vehicle or the like where the connector unit 100 is mounted.

The waterproof sealing member 60 of the present embodiment is integrally formed with the printed wiring board 30 by insert molding, for example. At the time of forming the waterproof sealing member 60, the printed circuit board 35 is prepared in advance. The printed circuit board 35 is obtained by printing cream solder in the form of paste on component mount positions on the printed wiring board 30, placing the interface connector 40, the electronic components 50, and the rear surface connector 90 on the printed wiring board 30, and performing a soldering step by adding heat in a reflow furnace.

After the printed circuit board 35 is prepared, the printed circuit board 35 is mounted in a mold for the waterproof sealing member 60 that is prepared in advance, the mold is closed and a hot melt material is injected after mold clamping, and insert molding is thereby performed. The waterproof sealing member 60 is thereby integrally formed on the printed wiring board 30 (the printed circuit board 35). In relation to a temperature at the time of insert molding, a material for insert molding and a step of reflow process are desirably adjusted such that molding can be performed at a lower temperature (such as from 180°C to 200°C) than a temperature (also referred to as "application temperature") of the soldering step in the reflow furnace. As a main component of the hot melt material, thermoplastic resin having a low-melting point, such as EVA, olefin, synthetic rubber, polyamide, or polyester, may be cited. However, such materials are not restrictive as long as the insert molding method described above can be implemented, and the inside of the case 70 can be separated into the first region 30a side and the second region 30b side from the standpoint of waterproofness.

By obtaining the waterproof sealing member 60 by insert molding, joining strength and durability can be increased, and the number of assembly steps can be reduced, and a positioning accuracy can be increased, for example.

### (Modification of Waterproof Sealing Member 60)

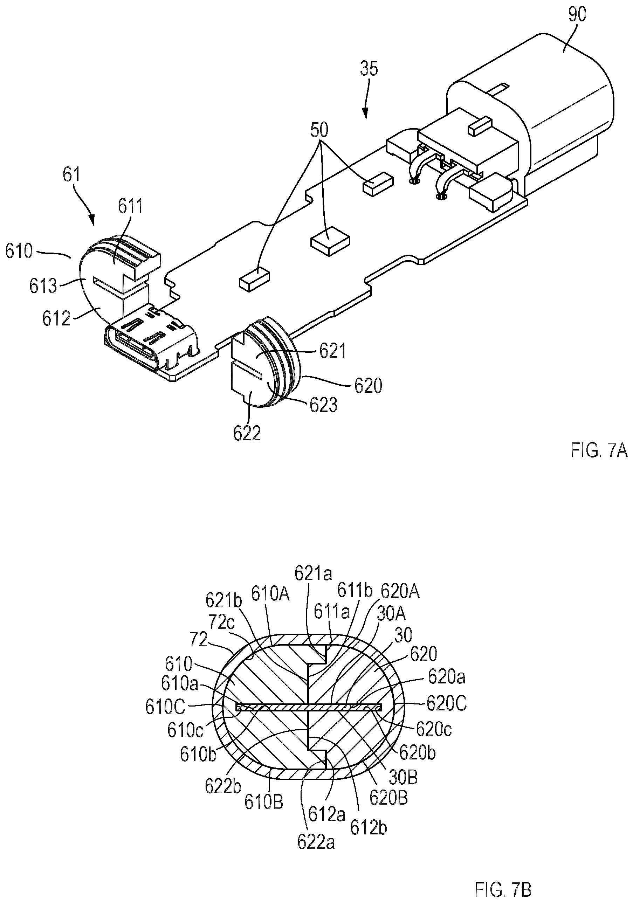

A method is adopted above where the waterproof sealing member 60 as one member is integrally formed with the printed circuit board 35. However, the waterproof sealing member 60 is not limited to be formed as one member, and a waterproof sealing member 61 formed from a plurality of non-annular members may also be used, as shown in FIGS. 7A and 7B, for example.

FIG. 7A is an exploded perspective view of the waterproof sealing member 61, where the waterproof sealing member 61 is to be mounted on the printed circuit board 35. FIG. 7B is a cross-sectional view seen from the interface connector 40 side, where the connector unit 100 where the waterproof sealing member 61 is mounted is cut along the surface including the boundary 30c. In FIG. 7B, the printed wiring board 30 and the rear surface connector 90 on the backward side (the rear side) of the boundary 30c are not shown. As shown in FIG. 7A, the waterproof sealing member 61 of a present modification is formed from a combination of two waterproof sealing members, i.e., a first waterproof sealing member 610 and a second waterproof sealing member 620. As in the case of the waterproof sealing member 60, examples of a material of the waterproof sealing member 61 include thermoplastic resin having a low-melting point, such as EVA, olefin, synthetic rubber, polyamide, and polyester, but as in the case of the waterproof sealing member 60, these materials are not restrictive.

As shown in FIG. 7A, the first waterproof sealing member 610 is formed from a pair of separating parts 611 and 612, and a coupling part 613 that couples the separating parts 611 and 612 into a substantially U-shape. As shown in FIG. 7B, the first waterproof sealing member 610 includes sandwiching surfaces 610a, 610b, and 610c for sandwiching the upper surface 30A and the lower surface 30B of the printed wiring board 30, and pressing surfaces 610A, 610B, and 610C for pressing the inner surface of the tubular part 72. As shown in FIG. 7A, the second waterproof sealing member 620 is formed from a pair of separating parts 621 and 622, and a coupling part 623 that couples the separating parts 621 and 622 into a substantially U-shape. As shown in FIG. 7B, the second waterproof sealing member 620 includes sandwiching surfaces 620a, 620b, and 620c for sandwiching the upper surface 30A and the lower surface 30B of the printed wiring board 30, and pressing surfaces 620A, 620B, and 620C for pressing the inner surface of the tubular part 72. As shown in FIGS. 7A and 7B, the first waterproof sealing member 610 and the second waterproof sealing member 620 have asymmetrical shapes, and form a substantially same shape as the waterproof sealing member 60 when combined together.

When mounting the waterproof sealing member 61 on the printed circuit board 35, the sandwiching surfaces 610a, 610b, and 610c of the first waterproof sealing member 610 and the sandwiching surfaces 620a, 620b, and 620c of the second waterproof sealing member 620 are brought into contact with and along the outer periphery 30c1 of the printed wiring board 30. Furthermore, an end part 611a of the first waterproof sealing member 610 and an end part 621a of the second waterproof sealing member 620, and an end part 611b of the first waterproof sealing member 610 and an end part 621b of the second waterproof sealing member 620 are brought into contact with each other while facing each other. In the same manner, an end part 612a of the first waterproof sealing member 610 and an end part 622a of the second waterproof sealing member 620, and an end part 612b of the first waterproof sealing member 610 and an end part 622b of the second waterproof sealing member 620 are brought into contact with each other while facing each other. Fixing is performed using an adhesive or the like so that such contact is maintained, or in other words, relative positions are not shifted, and the waterproof sealing member 61 is thereby disposed while being integrated with the printed circuit board 35. Sizes of the first waterproof sealing member 610 and the second waterproof sealing member 620 are such that the waterproof sealing member 61 as a whole has a substantially same size as the waterproof sealing member 60. Additionally, with respect to shapes at the contact part between the first waterproof sealing member 610 and the second waterproof sealing member 620 of the waterproof sealing member 61 of the present modification, the first waterproof sealing member 610 has a recessed shape and the second waterproof sealing member 620 has a protruding shape, but the shapes at the contact part are not limited to such shapes, and a more complex shape such as an interlocking structure may be adopted to achieve stronger joint than when joining by the waterproof sealing member 61 described above.

In the case where the waterproof sealing member includes a plurality of members, as in the case of the waterproof sealing member 61, a mold for insert molding does not have to be created, and a waterproof sealing member that is integrated with the printed wiring board 30 (the printed circuit board 35) can be formed by a sole process of joining, by preparing a necessary number of waterproof sealing members 61 in advance.

### (Case 70)

The printed circuit board 35 where the waterproof sealing member 60 is integrally formed, or the printed circuit board 35 where the waterproof sealing member 61 is integrally joined to the printed wiring board 30 is housed inside the case 70. For example, the case 70 is a molded article formed from thermoplastic resin such as ABS.

As shown in FIGS. 2A to 4, the case 70 includes tubular parts 71 and 72 having rectangular tube shapes, and the front plate part 74 positioned on a front end of the tubular part 72. The tubular part 71 has a tubular shape that is a size larger than the tubular part 72. The opening portion 73 that allows insertion/removal of a mating connector of the interface connector 40 is formed in the front plate part 74 of the tubular part 72. Two water discharge holes 76 are formed in the tubular part 72, or in other words, on the first region 30a side of the case 70, at lower parts on each of left and right sides across the front plate part 74. The opening portion 73 and the water discharge holes 76 each communicate with an inner space of the tubular part 72. Because the water discharge holes 76 are provided, even when water enters from the opening portion 73 side, the water is not kept retained on the first region 30a side inside the case 70, and is discharged outside the case 70 through the water discharge holes 76. As described above, because the interface connector 40 has a non-watertight structure, water received by the interface connector 40 is discharged outside the interface connector 40. As a result, the water is temporarily retained on the first region 30a side inside the case 70; however, the water discharged from the interface connector 40 is also eventually discharged outside the case 70 through the water discharge holes 76. Accordingly, even if a great amount of water is received from the opening portion 73, the water is not kept retained on the first region 30a side inside the case 70. Accordingly, the terminal 42 of the interface connector 40 may not rust due to water regardless of which orientation the connector unit 100 is attached to another device of a vehicle or the like where the connector unit 100 is mounted.

The printed circuit board 35 where the waterproof sealing member 60 is integrally formed, or the printed circuit board 35 where the waterproof sealing member 61 is joined to the printed wiring board 30 is pushed and inserted (inserted under pressure) from a rear end side of the tubular part 71 (opposite side of the case 70 from the front plate part 74), and is housed inside the case 70. As shown in FIG. 3A, sliders 71a, 71b, 71c, and 71d are formed on an inner surface of the tubular part 71, on side surface regions on both left and right sides. When performing push-in insertion of the printed circuit board 35 where the waterproof sealing member 60 (or the waterproof sealing member 61) is integrally formed into the case 70, an end part of the printed wiring board 30 in a width direction is inserted between the sliders 71a and 71b, and another end part is inserted and pushed in between the sliders 71c and 71d. Accordingly, as shown in FIG. 3B, the interface connector 40, the electronic component 50s, and the waterproof sealing member 60 (or the waterproof sealing member 61) on the printed wiring board 30, and the rear surface connector 90 excluding a fitting part 91a are housed inside the case 70 together with the printed wiring board 30, at predetermined positions and at predetermined heights.

The inside of the case 70 is separated into the first region 30a side and the second region 30b side by the waterproof sealing member 60 (or the waterproof sealing member 61). That is, in the case where the waterproof sealing member 60 is used as the waterproof sealing member, the pressing surfaces 60A, 60B, 60C, and 60D of the waterproof sealing member 60 press the inner surface of the tubular part 72, as shown in FIG. 6B. The waterproof sealing member 60 thus separates the inside of the case 70 into the first region 30a side and the second region 30b side. Furthermore, in the case where the waterproof sealing member 61 is used as the waterproof sealing member, the pressing surfaces 610A, 610B, and 610C of the first waterproof sealing member 610, and the pressing surfaces 620A, 620B, and 620C of the second waterproof sealing member 620 press the inner surface of the tubular part 72, as shown in FIG. 7B. The waterproof sealing member 61 thus separates the inside of the case 70 into the first region 30a side and the second region 30b side.

### (Rear Surface Connector 90)

On the end part 33 side of the second region 30b, the rear surface connector 90 to be connected to a harness connector 400 described later is mounted on the upper surface 30A of the printed wiring board 30. As shown in FIG. 4, the rear surface connector 90 includes a housing 91 and terminals 92. The housing 91 has a tubular shape, and is formed from the fitting part 91a to be fitted with the harness connector 400, and a base part 91b that covers a base end of the fitting part 91a. As shown in FIG. 3A, two terminal insertion holes 91c are formed in the base part 91b. The rear surface connector 90 according to the present embodiment includes two terminals 92. The terminal 92 has a shape that is bent in an L-shape, and a pair of protrusions 92a protruding in both sides in a width direction is formed on one side of the L-shape. As shown in FIGS. 3B and 4, the terminal 92 is attached to the housing 91 by having the one side of the L-shape pushed into the terminal insertion hole 91c. The side of the terminal 92 that is pushed in is exposed inside the fitting part 91a so as to be able to be connected to the harness connector 400. The other side of the L-shape of the terminal 92 is inserted and soldered to a through hole 31a provided on the end part 33 side of the printed wiring board 30.

### (Concrete Example 1 for Achieving Waterproof Region: Potting Resin 130)

After the waterproof sealing member 60 (or the waterproof sealing member 61) and the printed circuit board 35 are housed inside the case 70, the potting resin 130 is injected on the second region 30b side inside the case 70. Examples of a material of the potting resin 130 include, but are not limited to, urethane resin, epoxy resin, and silicone resin. In FIG. 3B, the injected potting resin 130 is indicated using a reference numeral, and is shown with no patterns without using diagonal lines or the like so that the potting resin 130 is distinguishable from the tubular part 71 and the printed wiring board 30. As shown in FIG. 3B, injection of the potting resin 130 is performed until the second region 30b side inside the case 70 is filled with the potting resin 130. Due to being filled with the potting resin 130, the inside of the case 70 may be such that the first region 30a side is a non-waterproof region, and the second region 30b side is a waterproof region.

### (Concrete Example 2 for Achieving Waterproof Region: Rear Surface Cover 80)

Waterproofness may be achieved by placing the second region 30b side inside the case 70 in a hollow state without injecting the potting resin 130, and by providing a rear surface cover 80 on the tubular part 71.

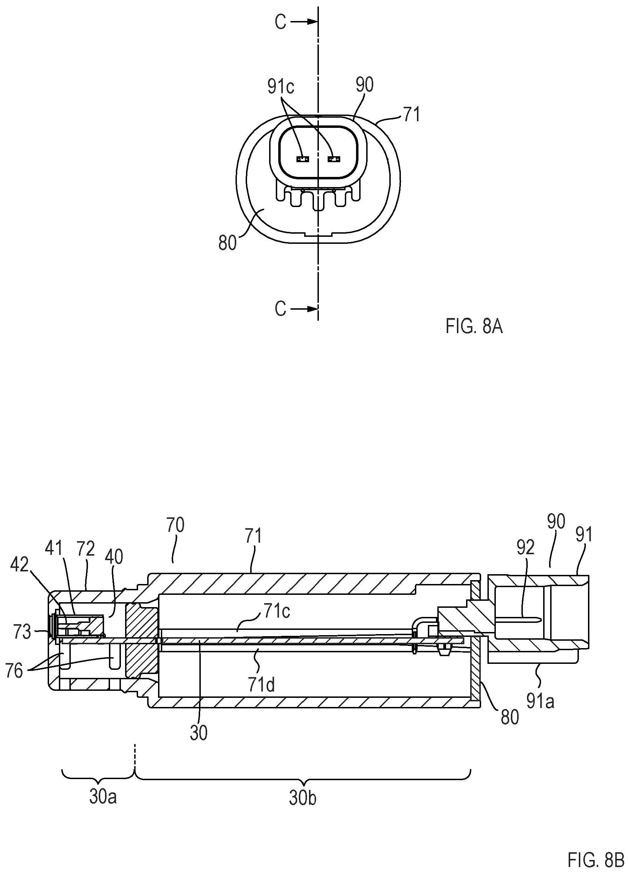

FIG. 8A is a rear view showing an example of the connector unit, where the rear surface cover 80 is included, and FIG. 8B is a cross-sectional view taken along a line C-C in FIG. 8A. Unlike as in FIGS. 3A and 3B, with the connector unit 100 shown in FIGS. 8A and 8B, the second region 30b side inside the case 70 is not filled with the potting resin 130. Instead, a rear end of the tubular part 71 of the case 70, or in other words, an end part of the case 70 on the second region 30b side is covered by the rear surface cover 80. The rear surface cover 80 includes a circular flat plate having a same shape as an inner diameter of the tubular part 71. A contact part between the rear surface cover 80 and the case 70, or in other words, a part between an inner peripheral surface of a rear end of the tubular part 71 and an outer peripheral surface of the rear surface cover 80, is tightly bonded by an adhesive or the like. By covering the rear end of the tubular part 71 by the rear surface cover 80, a waterproof function is achieved on the second region 30b side inside the case 70.

In the case where the rear surface cover 80 is provided, the rear surface cover 80 may be integrally formed between the fitting part 91a and the base part 91b. The base part 91b is thereby made a part of the rear surface cover 80, and the fitting part 91a is made to protrude rearward from the rear surface cover 80. However, the rear surface cover 80 may instead be formed as a separate body from the rear surface connector 90. For example, the rear surface cover 80 may be formed as a structure that holds the rear surface connector 90. It is conceivable to form the rear surface cover 80 from, but not limited to, a homogeneous material as the waterproof sealing member 60.

An annular groove may be formed on an outer peripheral surface of the rear surface cover 80, and a rubber seal having an annular shape may be attached to the annular groove, and the rubber seal may be sandwiched between the inner peripheral surface of the rear end of the tubular part 71 and the outer peripheral surface of the rear surface cover 80. The waterproof function on the second region 30b side inside the case 70 may thereby be even better complemented.

Even when the second region 30b side inside the case 70 is made a waterproof region by providing the rear surface cover 80, the second region 30b side inside the case 70 may be filled with the potting resin 130 to further increase the waterproof function. Additionally, in the case where the potting resin 130 is not injected, a moisture prevention coat may be applied on the printed wiring board 30 from the standpoint of waterproofness even when the rear surface cover 80 is provided. As a coating agent, a normal-temperature type fluorine coating agent may be used, or a coating agent that uses urethane-, acrylic-, or silicone-based resin as a film component may be used, for example.

Like the potting resin 130, the rear surface cover 80 may achieve a waterproof function on the second region 30b side inside the case 70, and also, the rear surface cover 80 may achieve the waterproof function at a lower cost than the potting resin 130.

Heretofore, the connector unit 100 according to the present embodiment has been described. The waterproof sealing member (the waterproof sealing member 60, the waterproof sealing member 61) of the connector unit 100 according to the present embodiment separates the inside of the case 70 into the first region 30a side and the second region 30b side. Furthermore, the second region 30b side inside the case 70 is a waterproof region.

The interface connector 40 is housed on the first region 30a side inside the case 70 that is a non-waterproof region, but the interface connector 40 according to the present embodiment has a non-watertight structure. Accordingly, even when the connector unit 100 is attached to another device of a vehicle or the like with the opening portion 73 facing upward and water is allowed to enter, or in other words, even when water is retained in a space on the first region 30a side inside the case 70 due to the interface connector 40 being used while facing upward, water is not kept retained in the interface connector 40 as long as the water is in small quantity, and the water is discharged outside the interface connector 40. Accordingly, the terminal 42 of the interface connector 40 is prevented from rusting due to water.

In the present embodiment, the second region 30b side inside the case 70 is a waterproof region, and a waterproof function is achieved. With the connector unit 100, even when water enters from the opening portion 73 side of the case 70, the water does not enter the second region 30b side inside the case thanks to the waterproof sealing member 60. Even if water passes through the waterproof sealing member 60, the second region 30b side is a waterproof region, and the water does not enter the second region 30b side inside the case. Even if water enters from a rear end side of the case 70, the second region 30b side inside the case 70 is a waterproof region, and the water does not enter the second region 30b side inside the case 70. Accordingly, the printed wiring board 30 and the electronic components 50 housed on the second region 30b side inside the case 70 are not affected by water regardless of which orientation the connector unit 100 is attached to another device of a vehicle or the like where the connector unit 100 is mounted.

As described above, the connector unit 100 of the present embodiment may relax a constraint on the attitude at the time of use, but the connector unit of the present invention is not limited to the embodiment described above. For example, a pigtail connector unit according to which a cable is directly connected to the printed wiring board 30 instead of the rear surface connector 90 and is drawn out may be adopted. Moreover, a connector unit that does not include external connections other than the interface connector 40 may be adopted.

### <Vehicle-Mounted Connector Device>

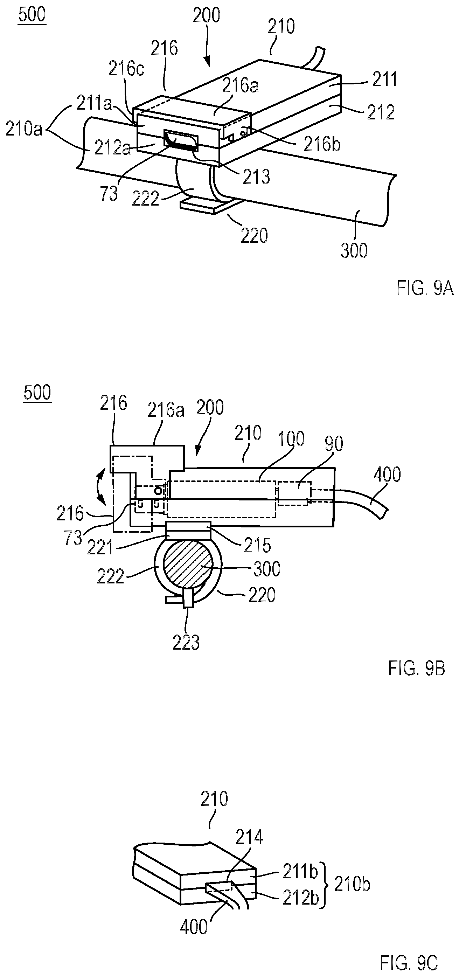

In the following, a vehicle-mounted connector device according to an example not encompassed by the claims but useful for understanding the present disclosure will be described. FIG. 9A is a diagram showing an example of attachment of the connector unit 100 to another device of a vehicle or the like, FIG. 9A showing a state where the connector unit 100 is attached to a handlebar of a motorcycle using a holding tool. FIG. 9B is a side view of FIG. 9A, and FIG. 9C is a rear view of FIG. 9A, FIG. 9C showing a part of a case holding part 210 and the harness connector 400. A vehicle-mounted connector device 500 according to the present example includes the connector unit 100 and a holding tool 200. As shown in FIGS. 9A and 9B, the vehicle-mounted connector device 500 is a device for attaching the connector unit 100 to a handlebar 300 of a motorcycle via the holding tool 200. The connector unit 100 indicated by a dotted line in FIG. 9B is attached with the opening portion 73 facing a driver's seat and being horizontal relative to the rear surface connector 90 (i.e., parallel to the ground).

In the present example, the handlebar 300 extends horizontally and sideways relative to a driver when the driver is seated on the driver's seat (not shown). Although not shown in FIGS. 9A and 9B, the handlebar 300 is integrated with a main body of the motorcycle via another support member or the like.

Main structural elements of the holding tool 200 are the case holding part 210 and a handlebar holding part 220.

### (Case Holding Part 210)

The case holding part 210 is for holding an outer periphery of the case 70 of the connector unit 100. The case holding part 210 includes a pair of a first holding part 211 and a second holding part 212 that form a box shape when seen from outside, a cap 216, and a holding base 215.

As shown in FIG. 9A, the first holding part 211 as a cover and the second holding part 212 as a base are fitted with each other so that an outer shape of the case holding part 210 is a box shape. Furthermore, an inner shape of the 210 is such that the entire connector unit 100 having a cylindrical shape is housed while being in close contact with the inner shape of the case holding part 210. A front surface 211a of the first holding part 211 and a front surface 212a of the second holding part 212 form a front surface 210a of the case holding part 210, and an opening portion 213 is formed in the front surface 210a, the opening portion 213 facing the interface connector 40 and the opening portion 73 of the connector unit 100 and allowing insertion/removal of a connector of an electronic device such as a smartphone into/from the interface connector 40. As shown in FIG. 9C, a rear surface 211b of the first holding part 211 and a rear surface 212b of the second holding part 212 form a rear surface 210b of the case holding part 210, and an opening portion 214 that allows insertion of a cable part of the harness connector 400 connected to the rear surface connector 90 of the connector unit 100 is formed in the rear surface 210b. Additionally, a water discharge hole, not shown, may be provided in a side surface or a bottom surface of the second holding part 212 such that water discharged from the water discharge hole 76 in the connector unit 100 may be discharged.

The cap 216 is turnably supported on the first holding part 211 of the case holding part 210. The cap 216 includes a lid part 216a for covering the opening portion 213 in the front surface 210a, and a pair of arm parts 216b and 216c that are integrally formed with the lid part 216a, the pair of arm parts 216b and 216c being on a rear side of the lid part 216a in a state closed state. A protruding part, not shown, that protrudes inward is provided on an end part of each arm part 216b, 216c, and each protruding part and a side surface of the first holding part 211 are turnably supported. Accordingly, the opening portion 213 may be covered by using the lid part 216a when the connector unit 100 is not used. Furthermore, at the time of use of the connector unit 100, or in other words, at a time of connecting a connector of an electronic device to the interface connector 40 from the driver's seat side, the lid part 216a is lifted so that the interface connector 40 faces outside, and the connector can be connected. In FIG. 9B, a turning direction of the cap 216 is indicated by an arrow, and the cap 216 in a closed state is indicated by a dash-dotted line.

The holding base 215 is integrally formed on a bottom surface of the second holding part 212 of the case holding part 210. The holding base 215 serves to fix the case holding part 210 on the handlebar holding part 220.

### (Handlebar Holding Part 220)

The handlebar holding part 220 is for holding the handlebar 300 of the motorcycle. The handlebar holding part 220 includes a base part 221, a belt 222, and a fixing part 223.

The base part 221 serves to fix the case holding part 210 and the handlebar holding part 220 to each other. That is, the base part 221 of the handlebar holding part 220 and the holding base 215 of the case holding part 210 are integrally coupled by being tightly fixed to each other by an adhesive or the like, for example. In FIGS. 9A and 9B, the base part 221 and the holding base 215 are completely fixed to each other so as not to allow relative movement, but instead, a turning mechanism part for turnably supporting the base part 221 and the holding base 215 may be provided between the two. In this case, the connector unit 100 mounted on the handlebar 300 via the holding tool 200 may be set to face a desired direction by using the turning mechanism part.

The belt 222 formed from an elastic member is integrally formed with the base part 221 in a manner capable of grasping an outer periphery of the handlebar 300 in a wrapping manner. The belt 222 has a length that allows the belt 222 to grasp the outer periphery of the handlebar 300 having a circular cross-section in a wrapping manner, and fastening strength of the belt 222 around the handlebar 300 is adjusted using the fixing part 223. The handlebar holding part 220 holds the handlebar 300 of the motorcycle due to the fastening strength being adjusted.

The configuration of the vehicle-mounted connector device 500 is as described above, and a method of attaching the connector unit 100 to the handlebar 300 of the motorcycle using the holding tool 200 is as described below. First, the handlebar 300 is held by the handlebar holding part 220 (step S1). More specifically, as shown in FIG. 9B, the handlebar 300 having a circular cross-section is circumferentially grasped using the belt 222, and the fastening strength of the belt 222 around the handlebar 300 is adjusted using the fixing part 223. When the handlebar 300 is held by the belt 222, an attachment angle of the belt 222 is adjusted using the fixing part 223 so that the opening portion 213 of the case holding part 210 integrally formed with the handlebar holding part 220 faces a direction desired by the driver. Accordingly, attachment to the handlebar 300 may be such that the opening portion 73 of the connector unit 100 faces upward, for example.

Next, the connector unit 100 is held by the case holding part 210 (step S2). More specifically, engagement of the first holding part 211 and the second holding part 212 is released and the first holding part 211 as a cover is opened, and the connector unit 100 is mounted inside the second holding part 212. At this time, the connector unit 100 is mounted in the second holding part 212 in such a way that the opening portion 73 of the connector unit 100 faces the opening portion 213 of the case holding part 210, and the cable part of the harness connector 400 mounted on the rear surface connector 90 of the connector unit 100 is inserted through the opening portion 214 of the case holding part 210. After the connector unit 100 is mounted in the second holding part 212, the first holding part 211 is closed and the first holding part 211 and the second holding part 212 are fitted together, and the connector unit 100 is housed in the case holding part 210. Additionally, in the case of the holding tool 200 provided with the turning mechanism part described above, the connector unit 100 may be adjusted to face a desired direction by using a turning support function of the turning mechanism part after step S2. Accordingly, attachment to the handlebar 300 may be such that the opening portion 73 of the connector unit 100 faces upward, for example.

As described above, the vehicle-mounted connector device 500 according to the present example includes the connector unit 100, and thus, an effect that same as that of the connector unit 100 described above may be obtained. Furthermore, because the vehicle-mounted connector device 500 includes the holding tool 200, attachment to a vehicle such as a motorcycle may be in such a way that the connector unit 100 faces a direction desired by a user. More particularly, in the case where the connector unit 100 of the present example is used as the vehicle-mounted connector device 500 including the holding tool to be attached to the handlebar of a motorcycle, a degree of freedom can be ensured with respect to an angle of attachment to the handlebar, and attachment at an attitude where the opening portion 73 faces upward is enabled.

Additionally, a method of attachment of the vehicle-mounted connector device 500 to a vehicle is not limited to the method described above, and for example, the order of step S1 and step S2 may be changed or step S1 and step S2 may be performed in parallel.

### [DESCRIPTION OF REFERENCE NUMERALS]

30: printed wiring board
30A: upper surface
30B: lower surface
30c: boundary
30c1: outer periphery
31a: through hole
32, 33: end part
35: printed circuit board
40: interface connector
41: shell
42: terminal
50: electronic component
60, 61: waterproof sealing member
60A, 60B, 60C, 60D: pressing surface
70: case
71, 72: tubular part
71a, 71b, 71c, 71d: slider
72c: inner periphery
73: opening portion
74: front plate part
76: water discharge hole
80: rear surface cover
90: rear surface connector
91: housing
91a: fitting part
91b: base part
91c: terminal insertion hole
92: terminal
92a: protrusion
100: connector unit
200: holding tool
210: case holding part
210a, 211a, 212a: front surface
210b, 211b, 212b: rear surface
211: first holding part
212: second holding part
213, 214: opening portion
215: holding base
216: cap
216a: lid part
216b, 216c: arm part
220: handlebar holding part
221: base part
222: belt
223: fixing part
300: handlebar (of motorcycle)
400: harness connector
500: vehicle-mounted connector device
610: first waterproof sealing member
610a, 610b, 610c: sandwiching surface
610A, 610B, 610C: pressing surface
611, 612, 621, 622: separating part
611a, 612a, 621a, 622a: end part
611b, 612b, 621b, 622b: end part
613, 623: coupling part
620: second waterproof sealing member
620a, 620b, 620c: sandwiching surface
620A, 620B, 620C: pressing surface

## Claims

1. A connector unit (100) comprising:
a printed wiring board (30) having a flat plate shape, and including a first region (30a) and a second region (30b) that is adjacent to and continuous with the first region (30a);
an interface connector (40) mounted on the first region (30a) of the printed wiring board (30), and the interface connector (40) including a terminal (42) covered by a metal shell (41) having a non-watertight structure;
a waterproof sealing member (60,61) that covers a boundary (30c) between the first region (30a) and the second region (30b) of the printed wiring board (30); and
a case (70) including a front plate part (74) and an opening portion (73), the terminal (42) being positioned facing outside of the case (70) through the opening portion (73) provided in the front plate part (74) of the case (70), the opening portion (73) being for allowing insertion/removal of a mating connector of the interface connector (40), the case being for housing the printed wiring board (30), the interface connector (40), and the waterproof sealing member (60,61), wherein
the waterproof sealing member (60,61) is formed so as to cover an outer periphery of the boundary (30c) of the printed wiring board (30) and an inner periphery of the case (70) facing toward the outer periphery of the boundary (30c) in a close contact manner and separate inside of the case (70) into the first region side and the second region side across the waterproof sealing member (60,61), and
the second region side inside the case (70) is a waterproof region.

2. The connector unit (100) according to claim 1, wherein the waterproof sealing member (60,61) is integrally formed with the printed wiring board (30) by insert molding.

3. The connector unit (100) according to claim 1, wherein the waterproof sealing member (60,61) is formed from a plurality of non-annular members.

4. The connector unit (100) according to any one of claims 1 to 3, wherein a water discharge hole (76) is provided in the first region side of the case (70).

5. The connector unit (100) according to any one of claims 1 to 3, wherein the second region side inside the case (70) is made the waterproof region by being filled with potting resin.

6. The connector unit (100) according to any one of claims 1 to 3, wherein the second region side inside the case (70) is made the waterproof region due to a rear surface cover (80) for covering an end part on the second region side being provided.

## Patentansprüche

1. Verbindereinheit (100) mit:
einer Leiterplatte (30), die eine flache Plattenform hat und einen ersten Bereich (30a) und einen zweiten Bereich (30b) enthält, der an den ersten Bereich (30a) angrenzt und mit diesem zusammenhängt;
einem Schnittstellenverbinder (40), der an dem ersten Bereich (30a) der Leiterplatte (30) angebracht ist, wobei der Schnittstellenverbinder (40) einen Anschluss (42) enthält, der durch eine Metallschale (41) abgedeckt ist, die eine nicht wasserdichte Struktur hat;
einem wasserdichten Dichtungselement (60, 61), das eine Grenze (30c) zwischen dem ersten Bereich (30a) und dem zweiten Bereich (30b) der Leiterplatte (30) abdeckt; und
einem Gehäuse (70) einschließlich einem vorderen Plattenteil (74) und einem Öffnungsabschnitt (73), wobei der Anschluss (42) durch den Öffnungsabschnitt (73), der in dem vorderen Plattenteil (74) des Gehäuses (70) bereitgestellt ist, zu der Außenseite des Gehäuses (70) weisend positioniert ist, wobei der Öffnungsabschnitt (73) dazu dient, das Einsetzen/Entfernen eines Gegenverbinders des Schnittstellenverbinders (40) zu ermöglichen, wobei das Gehäuse dazu dient, die Leiterplatte (30), den Schnittstellenverbinder (40) und das wasserdichte Dichtungselement (60, 61) aufzunehmen, wobei
das wasserdichte Dichtungselement (60, 61) derart ausgebildet ist, dass es einen Außenumfang der Grenze (30c) der Leiterplatte (30) und einen Innenumfang des Gehäuses (70), der dem Außenumfang der Grenze (30c) zugewandt ist, in einer engen Kontaktweise abdeckt und das Innere des Gehäuses (70) in die Seite des ersten Bereichs und die Seite des zweiten Bereichs über das wasserdichte Dichtungselement (60, 61) trennt, und
die Seite des zweiten Bereichs innerhalb des Gehäuses (70) ein wasserdichter Bereich ist.

2. Verbindereinheit (100) nach Anspruch 1, wobei das wasserdichte Dichtungselement (60, 61) durch Umspritzen integral mit der Leiterplatte (30) ausgebildet ist.

3. Verbindereinheit (100) nach Anspruch 1, wobei das wasserdichte Dichtungselement (60, 61) aus einer Vielzahl von nicht-ringförmigen Elementen ausgebildet ist.

4. Verbindereinheit (100) nach einem der Ansprüche 1 bis 3, wobei ein Wasserauslassloch (76) in der Seite des ersten Bereichs des Gehäuses (70) bereitgestellt ist.

5. Verbindereinheit (100) nach einem der Ansprüche 1 bis 3, wobei die Seite des zweiten Bereichs innerhalb des Gehäuses (70) durch Füllen mit Gießharz zu dem wasserdichten Bereich gemacht wird.

6. Verbindereinheit (100) nach einem der Ansprüche 1 bis 3, wobei die Seite des zweiten Bereichs innerhalb des Gehäuses (70) aufgrund der Bereitstellung einer Rückflächenabdeckung (80) zum Abdecken eines Endteils auf der Seite des zweiten Bereichs zu dem wasserdichten Bereich gemacht wird.

## Revendications

1. Unité de connecteur (100) comprenant :
une carte de câblage imprimé (30) ayant une forme de plaque plate, et comprenant une première région (30a) et une seconde région (30b) qui est adjacente à et continue avec la première région (30a) ;
un connecteur d'interface (40) monté sur la première région (30a) de la carte de câblage imprimé (30), et le connecteur d'interface (40) comprenant une borne (42) recouverte par une coque métallique (41) ayant une structure non étanche à l'eau ;
un élément d'étanchéité étanche à l'eau (60, 61) qui recouvre une limite (30c) entre la première région (30a) et la seconde région (30b) de la carte de câblage imprimé (30) ; et
un boîtier (70) comprenant une partie de plaque avant (74) et une partie d'ouverture (73), la borne (42) étant positionnée face à l'extérieur du boîtier (70) à travers la partie d'ouverture (73) mise en place dans la partie de plaque avant (74) du boîtier (70), la partie d'ouverture (73) étant destinée à permettre l'insertion/le retrait d'un connecteur d'accouplement du connecteur d'interface (40), le boîtier étant destiné à loger la carte de câblage imprimé (30), le connecteur d'interface (40), et l'élément d'étanchéité étanche à l'eau (60, 61), dans laquelle
l'élément d'étanchéité étanche à l'eau (60, 61) est formé de manière à recouvrir une périphérie externe de la limite (30c) de la carte de câblage imprimé (30) et une périphérie interne du boîtier (70) faisant face à la périphérie externe de la limite (30c) d'une manière en contact étroit et séparer l'intérieur du boîtier (70) en le côté de première région et le côté de seconde région à travers l'élément d'étanchéité étanche à l'eau (60, 61), et
le côté de seconde région à l'intérieur du boîtier (70) est une région étanche à l'eau.

2. Unité de connecteur (100) selon la revendication 1, dans laquelle l'élément d'étanchéité étanche à l'eau (60, 61) est formé d'un seul tenant avec la carte de câblage imprimé (30) par moulage par insertion.

3. Unité de connecteur (100) selon la revendication 1, dans laquelle l'élément d'étanchéité étanche à l'eau (60, 61) est formé à partir d'une pluralité d'éléments non annulaires.

4. Unité de connecteur (100) selon l'une quelconque des revendications 1 à 3, dans laquelle un trou d'évacuation d'eau (76) est mis en place dans le côté de première région du boîtier (70).

5. Unité de connecteur (100) selon l'une quelconque des revendications 1 à 3, dans laquelle le côté de seconde région à l'intérieur du boîtier (70) est rendu la région étanche à l'eau en étant rempli de résine d'enrobage.

6. Unité de connecteur (100) selon l'une quelconque des revendications 1 à 3, dans laquelle le côté de seconde région à l'intérieur du boîtier (70) est rendu la région étanche à l'eau en raison de la mise en place d'un couvercle de surface arrière (80) pour recouvrir une partie d'extrémité sur le côté de seconde région.
